# EUROPEAN PATENT APPLICATION

(11) **EP 3 124 649 A1**
(43) Date of publication of application: **01.02.2017**
(21) Application number: 15768863.1
(22) Date of filing: 10.03.2015
(51) Int. Cl.: C23C 14/56, C23C 14/04, C23C 14/24

(54) **FILM-FORMATION DEVICE AND FILM-FORMATION METHOD**

(30) Priority: 25.03.2014 JP 2014062751
(71) Applicant: ULVAC, Inc., Chigasaki-shi, Kanagawa 253-8543 (JP)
(72) Inventor: NAKAO, Hirotoshi, Chigasaki-shi Kanagawa 253-8543 (JP); SATOU, Seiichi, Chigasaki-shi Kanagawa 253-8543 (JP); SHIBA, Satoshi, Chigasaki-shi Kanagawa 253-8543 (JP); BANNNAI, Yuuya, Chigasaki-shi Kanagawa 253-8543 (JP); KIMURA, Toru, Chigasaki-shi Kanagawa 253-8543 (JP)
(74) Representative: Epping - Hermann - Fischer
(86) International application number: PCT/JP2015/001306
(87) International publication number: WO 2015/146025

(57) **Abstract**

There is provided a film forming apparatus in which, when film is formed continuously in a predetermined pattern on one surface of a base material by feeding a film forming material beyond a mask while a sheet-like base material is caused to travel at a predetermined speed, a portion of the sheet-like base material and a portion of the sheet-like transcription substrate can be aligned at a high accuracy, and in which the cost for the apparatus and the running cost can further be reduced.

On condition that a direction from the film forming means (9) toward the sheet-like base material (Sw) is defined to be an upside, the mask material traveling means (4) has: a parallel travel region forming unit (42a, 42b) which causes a portion (Sm1) of the sheet-like mask material (Sm) to travel in parallel with, and at a predetermined vertical clearance with, a portion Sm1 of the sheet-like mask material (Sm), relative to a portion Sw1 of the sheet-like base material to be caused to travel in one direction; and a driving unit (42d, DM2) which causes the sheet-like mask material to travel in synchronization with the sheet-like base material. The parallel travel region forming unit and the driving unit are disposed on a single rack (41).

## Description

### Technical Field

The present invention relates to a film forming apparatus and a film forming method and, in particular, to an arrangement in which, while a sheet-like (or sheet-shaped) base material is caused to travel at a predetermined speed, a film forming material is fed beyond a mask so as to form a film in succession on one surface of the base material in a predetermined pattern.

### Background Art

This kind of film forming apparatus is known, for example, in Patent Document 1. The apparatus in question is provided with: a base material traveling means for causing a sheet-like (or band-like) base material to travel; a transcription substrate traveling means for causing a sheet-like transcription substrate to travel in an annular form; a film forming means for feeding a film forming material to a portion of the sheet-like transcription substrate; and a mask material traveling means for causing the sheet-like mask material (shadow mask) to travel in synchronization with the transcription substrate in partially close contact therewith, the mask material serving to limit the scope of supplying the film forming material to the transcription substrate. Then, by feeding the film forming material beyond the mask to the transcription substrate, what has been formed into a film of a predetermined pattern on one surface of the sheet-like transcription substrate is transcribed to the sheet-like substrate. In this manner, a predetermined film is formed continuously in a predetermined pattern on one surface of the sheet-like base material. According to this example, after having formed a predetermined film on the transcription substrate beyond the mask, the predetermined film is then transcribed to the sheet-like base material. Therefore, by the amount of increase in the processing steps the apparatus itself will become larger in size and more complicated. Not only is the cost of the apparatus higher but also, due to the necessity of the transcription substrate, is the manufacturing cost higher.

By the way, in the above-mentioned prior art example, the portion of the sheet-like substrate and the portion of the sheet-like transcription substrate are positioned in parallel with each other in a vertical positional relationship with each other. In the transcription region inclusive of the part where transcription to the sheet-like base material is to take place, there is provided a gap between both the portions. Therefore, in order to perform alignment of the transcription substrate relative to the portion of the base material, there is provided an alignment mechanism. In this case, the alignment mechanism performs alignment of the transcription substrate relative to the base material by adjusting a widthwise position and angle of a pair of guide rolls that are disposed in a manner to pinch the transcription portion. However, in this kind of method, the tension to be applied to the sheet-like transcription substrate or to the sheet-like mask material becomes non-uniform, thereby giving rise to the occurrence of strains to the sheet-like transcription substrate and the sheet-like mask material. Therefore, there is a possibility that alignment cannot be made at a higher accuracy.

### Prior Art Documents

### Patent Documents

- Patent Document 1:: JP 2003-173870 A

### Summary of the Invention

### Problems to be Solved by the Invention

In view of the above points, this invention has a problem of providing a film forming apparatus and a film forming method in which, when a film is formed continuously in a predetermined pattern on one surface of the base material by feeding the film forming material beyond the mask while the sheet-like base material is caused to travel at a predetermined speed, the portion of the sheet-like base material and the portion of the sheet-like transcription substrate can be aligned with each other at a high accuracy, and also the apparatus cost and the running cost can be reduced.

### Means of Solving the Problems

In order to solve the above-described problems, the film forming apparatus according to this invention has, inside a vacuum processing chamber: a base material traveling means for causing a sheet-like base material to travel at a predetermined speed; a film forming means for feeding a film forming material to a portion of the sheet-like base material which travels in one direction; and a mask material traveling means for causing to travel a sheet-like mask material which limits a scope of feeding of the film forming material to the sheet-like base material. On condition that a direction from the film forming means toward the sheet-like base material is defined to be upper side, the mask material traveling means comprises: a parallel travel region forming unit which causes such a portion of the sheet-like mask material as is positioned on a lower side of the sheet-like base material that travels in one direction, to travel in parallel with the sheet-like base material; and a driving unit which causes the sheet-like mask material to travel in synchronization with the sheet-like base material. The parallel travel region forming unit and the driving unit are disposed on a single rack.

According to this invention, while causing the portion of the sheet-like mask material to travel in parallel with such a portion of the sheet-like base material as is caused to travel in one direction, the film forming material is directly fed from a film forming source, thereby forming a film beyond the sheet-like mask material. Therefore, unlike the above-mentioned conventional example, the mechanism and the like for once transcribing to another base material becomes unnecessary. It is therefore possible to reduce the cost for the apparatus as well as the cost for running the apparatus. In addition, the elements for causing the sheet-like mask material to travel are mounted on a single rack into a unit. In this manner, an arrangement has been employed in which the rack itself is moved so that the portion of the sheet-like mask material is aligned with the portion of the sheet-like base material. At the time of aligning the portion of the sheet-like mask material with the portion of the sheet-like base material, the traveling state of the sheet-like mask material to which a certain tension has been applied, will not vary. Therefore, the sheet-like mask material and, in turn, its mask pattern will never give rise to a forced strain. As a result, the portion of the sheet-like base material and the sheet-like mask material can be subjected to continuous film forming on the sheet-like base material in an accurate pattern in a state in which the portion of the sheet-like base material and the sheet-like mask material are aligned with each other at a high accuracy. By the way, preferably, the elements for causing the sheet-like mask material to travel, as described above, shall be disposed on the single rack so as to make them into a unit. And the unit in which the sheet-like mask material is set in position in advantage shall preferably be prepared in a plurality of numbers in advance. By making such an arrangement, in case the one in use must be subjected to maintenance (e.g., replacement, cleaning, and the like of the sheet-like mask material), another unit in which, e.g., an already cleaned sheet-like mask material is set in position can be set into the film forming apparatus. In this manner, film forming on the sheet-like base material can be started again at the shortest waiting time.

In this invention, the film forming apparatus preferably further comprises: a speed detecting means for detecting a speed at which the sheet-like base material or the sheet-like mask material is caused to travel; on condition that a direction in which the portion of the sheet-like base material is caused to travel in one direction is defined to be an X-axis direction, a first detecting means for detecting an amount of relative displacement, in the X-axis direction, of the sheet-like mask material relative to the sheet-like base material in a region in which the portion of the sheet-like base material and the portion of the sheet-like mask material are positioned in a vertical positional relationship with each other. The film forming apparatus is arranged such that: one of the sheet-like base material and the sheet-like mask material is made to coincide with a detected value, by the speed detecting means, of the other of the sheet-like base material and the sheet-like mask material, thereby synchronizing the sheet-like base material and the sheet-like mask material with each other and that: one of the base material traveling means and the driving unit is controlled depending on the detected value by the first detecting means, thereby correcting the position of the sheet-like mask material relative to the sheet-like base material.

Further, in this invention, on condition that a direction in which the portion of the sheet-like base material is caused to travel in one direction is defined to be an X-axis direction, that the direction crossing the X-axis direction at right angles is defined to be Y-axis direction, and that a direction of rotation about a Z-axis as a vertical direction is defined to be Θz direction, the rack is disposed on a Y-Θz stage. The apparatus preferably further comprises: a second detecting means for detecting, in a region in which the portion of the sheet-like base material and the portion of the sheet-like mask material are positioned in a vertical positional relationship with each other, a relative amount of displacement in the Y-axis direction of the sheet-like mask material relative to the sheet-like base material, or an angle to be formed by the traveling direction of the sheet-like base material and the traveling direction of the sheet-like mask material. Depending on a detected value by the second detecting means, at least one of movement in the Y-axis direction of, and rotation about the Θ direction of, the rack is performed by the Y-Θz stage, thereby correcting the position of the sheet-like mask material relative to the sheet-like base material.

Further, in this invention, in case the mask material traveling means causes to parallelly travel the portion of the sheet-like mask material at a predetermined vertical clearance to the portion of the sheet-like base material that is caused to travel in said one direction, the Y-Θz stage preferably comprises: a driving means for vertically moving the Y-Θz stage; a third detecting means for detecting a vertical clearance between the sheet-like base material and the sheet-like mask material in the region in which the portion of the sheet-like base material and the portion of the sheet-like mask material are positioned in a vertical positional relationship with each other. Depending on a detected value by the third detecting means, the Y-Θz stage is vertically moved by the driving means, thereby correcting the height position of the sheet-like mask material relative to the sheet-like base material.

On the other hand, the film forming apparatus may be arranged to comprise an urging means for urging, in an upper region of the film forming means, the portion of the sheet-like base material toward the portion of the sheet-like mask material so as to bring the sheet-like base material into contact with the sheet-like mask material.

By the way, in this invention, in view of the ease of performing maintenance and the like, preferably the film forming apparatus further comprises a moving means for allowing the mask material traveling means to be movable in the Y-axis direction between inside the vacuum processing chamber and outside the vacuum processing chamber.

Further, in order to solve the above-mentioned problems, the film forming method of this invention in which a film is formed forming a film on a sheet-like base material by using the above-mentioned film forming apparatus comprises: on condition that alignment marks respectively disposed on the sheet-like base material and on the sheet-like mask material at a predetermined interval from one another in the X-axis direction, the first detecting means and the second detecting means are defined to be imaging means respectively: capturing with the imaging means the alignment marks in the portion of the sheet-like base material and in the portion of the sheet-like mask material, and analyzing the captured images, thereby detecting: a relative amount of displacement (ΔX) in the X-axis direction of the sheet-like mask material relative to the sheet-like base material; and at least one of a relative amount of displacement (Δ Y) in the Y-axis direction of the sheet-like mask material relative to the sheet-like base material, and an angle (Δ Θz) formed by a traveling direction of the sheet-like base material and a traveling direction of the sheet-like mask material. The method comprises: based on the detected relative amount of displacement (ΔX), giving a command of an amount of change in the traveling speed of the sheet-like base material or of the sheet-like mask material to one of the base material traveling means and the driving unit and; in synchronization therewith, based on at least one of the detected relative amount of displacement (ΔY) and the angle (ΔΘz), giving a command, to the Y - Θz stage, of a movement amount of at least one of the movement in the Y-axis direction and rotation in the Θ direction of the rack, thereby correcting the traveling speed and the position of the sheet-like mask material relative to the sheet-like base material.

According to this arrangement, in a state in which the portion of the sheet-like base material and the portion of the sheet-like mask material are aligned with each other at a high accuracy, the film forming material can be fed beyond the mask to the sheet-like base material that is caused to travel at a predetermined speed, whereby a film can be formed continuously in a predetermined pattern on one surface of the base material.

By the way, in case the portion of the sheet-like mask material is caused to travel in parallel with the portion of the sheet-like base material which is caused to travel in parallel with the portion of the sheet-like base material that is caused to travel in one direction by the mask material traveling means while keeping a predetermined vertical clearance therebetween, thereby performing film forming in the region in question, should the portion of the sheet-like mask material be tilted slightly relative to the portion of the sheet-like base material, thereby giving rise to a relatively large clearance between the two, blurs attributable to the mask conditions will occur in the region concerned and film forming cannot be performed at a high accuracy.

According to this invention, in case the mask material traveling means further comprises: a tilting means for tilting the portion of the sheet-like mask material relative to the sheet-like base material, both said materials being arranged to travel in parallel with each other, the third detecting means being disposed in the X-axis direction in a plurality of numbers at a predetermined distance from one another. The method preferably comprises: detecting tilts of the sheet-like mask material relative to the sheet-like base material from a distance, as respectively detected by the third detecting means, in the Z-axis direction between the portion of the sheet-like base material and the portion of the sheet-like mask material; giving a command of an amount of tilting of the sheet-like mask material to the tilting means based on the detected tilts, thereby correcting the tilts and, after correcting the tilts, correcting the traveling speed and the position. According to this arrangement, it is possible to perform film forming on one surface of the sheet-like base material in a predetermined pattern in succession at a high accuracy without giving rise to blurs attributable to the mask conditions.

On the other hand, the method may further comprise: analyzing the images captured by the imaging means to respectively detect a relative amount of displacement (ΔX) in the X-axis direction, and at least one of a relative amount of displacement (ΔY) in the Y-axis direction and an angle (ΔΘz); thereafter detecting tilts of the sheet-like mask material relative to the sheet-like base material from the distance in the Z-axis direction between the portion of the sheet-like base material and the portion of the sheet-like mask material as respectively detected by the third detecting means; correcting the tilts based on the detected tilts by commanding to the tilting means the amount of tilting of the sheet-like mask material relative to the sheet-like base material, and calculating an error of movement in the X-axis direction and in the Y-axis direction of the sheet-like mask material relative to the sheet-like base material accompanied by the correction of the tilts; commanding to one of the base material traveling means and the driving unit an amount of change in traveling speed of the sheet-like base material or the sheet-like mask material by adding the error of movement to the relative amount of displacement (ΔX), and at least one of the relative amount of displacement (ΔY) in the Y-axis direction and the angle (ΔΘz); and in synchronization therewith, commanding the amount of movement of at least one of the movement in the Y-axis direction of, and the rotation in the Θ direction of, the rack, thereby correcting the traveling speed of, and the position of, the sheet-like mask material relative to the sheet-like base material. According to this arrangement, the position of the sheet-like mask material relative to the sheet-like base material can advantageously be corrected soonest possible.

### Brief Description of the Drawings

FIG. 1 is a schematic perspective view showing an arrangement of a film forming apparatus according to an embodiment of this invention.
FIG. 2 is a schematic sectional view showing the film forming apparatus shown in FIG. 1.
FIG. 3(a) and FIG. 3(b) are figures explaining the positional displacements of a sheet-like base material relative to a sheet-like mask material.
FIG. 4 is a figure explaining the aligning of the sheet-like base material relative to the sheet-like mask material.
FIG. 5 is a sectional view showing in enlargement an essential portion of the film forming apparatus relating to a modified embodiment of this invention.
FIG. 6 is a sectional view showing in enlargement an essential portion of the film forming apparatus relating to another modified embodiment of this invention.
FIG. 7(a) and FIG. 7(b) are a front view and a side view, respectively, showing in enlargement an essential portion of the film forming apparatus relating to still another modified embodiment of this invention.

### Modes for Carrying out the Invention

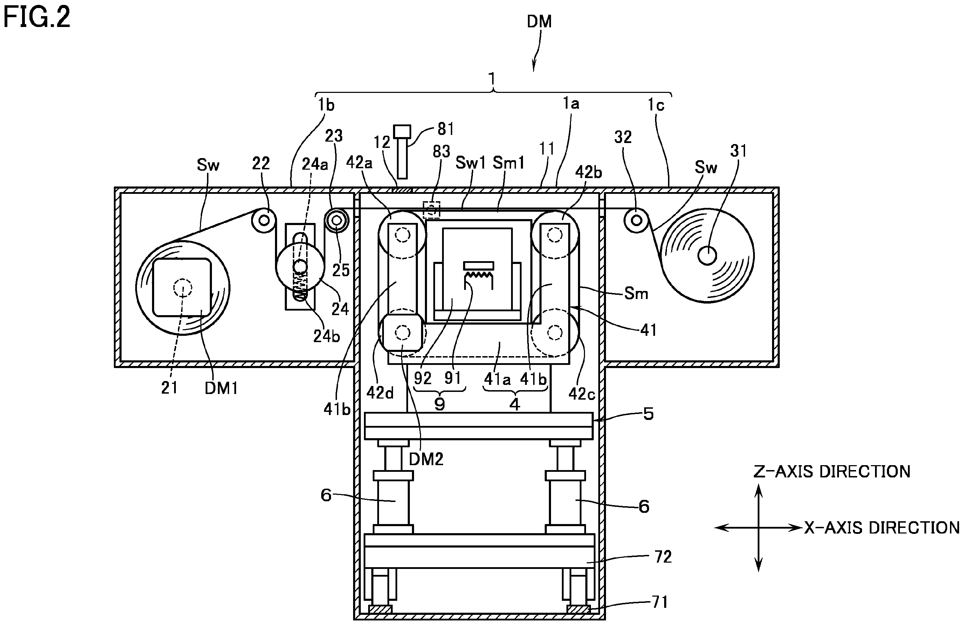

With reference to the drawings, a description will be made hereinbelow of an embodiment of a film forming apparatus according to this invention in which a film forming means is made to serve as a resistance board and in which, while a sheet-like base material Sw is caused to travel at a given speed, a predetermined thin film is continuously formed beyond a mask Sm. In the following description the direction in which a portion Sw1 of the sheet-like base material Sw is caused to be transferred in one direction inside a film forming chamber 1a is defined to be X-axis direction (i.e., the right-and-left direction in FIG. 2), the direction crossing this X-axis direction on one and the same plane is defined to be Y-axis direction, the direction crossing at right angles both the X-axis direction and the Y-axis direction is defined to be Z-axis direction (i.e., the up-and-down or vertical direction in FIG. 2), and the direction of rotation about the Z-axis is defined to be Θz direction. Further, the terms denoting the directions such as up, down, left and right shall be based on FIG. 2.

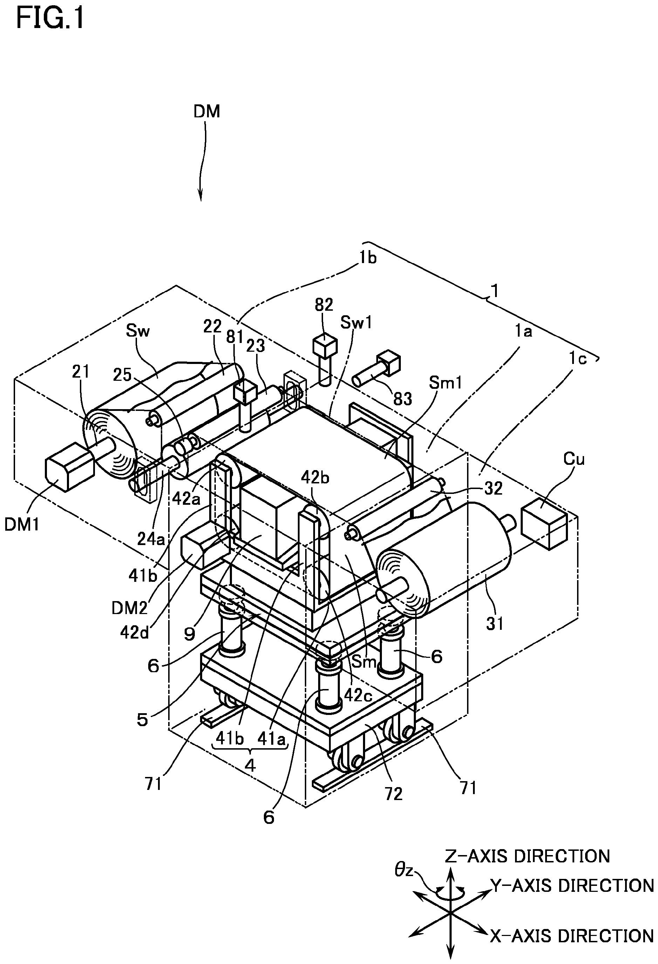

With reference to FIGS. 1 and 2, a reference sign DM denotes a film forming apparatus according to an embodiment of this invention. The film forming apparatus DM is provided with a vacuum processing chamber 1 which is connected to a vacuum pump (not illustrated) and is evacuated to a predetermined pressure. The vacuum processing chamber 1 is constituted by a film forming chamber 1a which performs film forming processing relative to a sheet-like base material Sw, an upstream-side auxiliary chamber 1b, and a downstream-side auxiliary chamber 1c, the auxiliary chambers being disposed on the left side and right side, respectively, as seen in the X-axis direction of the film-forming chamber 1a.

The upstream-side auxiliary chamber 1b is provided with: a feed roller 21 which holds the sheet-like base material Sw in a round-around state and which is driven to rotate by an electric motor DM1, and an upstream-side guide roller 22 and a downstream-side guide roller 23 which wind around the sheet-like base material Sw fed out of the feed roller 21 to thereby guide the sheet-like base material to an upper space of the film forming chamber 1a. Inside the upstream-side auxiliary chamber 1b there is further disposed a dancer roller 24 which is movable in the Z-axis direction, the dancer roller being positioned between the upstream-side guide roller 22 and the downstream-side guide roller 24. The dancer roller 24 is provided on its rotary shaft 24a with a spring 24b which urges the rotary shaft 24a upward. It is thus so arranged that the tension of the sheet-like base material Sw that passes through the film forming chamberla can be maintained at a predetermined value. It is to be noted that the arrangement to maintain the tension of the sheet-like base material Sw at the predetermined value shall not be limited to the one described above. Instead, by means of the conventional actuator the tension of the sheet-like base material Sw may be arranged to be variable. Further, the downstream-side guide roller 23 is provided with a sensor 25 as a means for detecting the rotational speed of the downstream-side guide roller 23. It is thus so arranged that, based on the rotational speed, the feed speed of the sheet-like base material Sw into the film forming chamber 1a can be detected by the rotational speed.

The downstream-side auxiliary chamber 1c is provided with: a take up roller 31 which takes up and recover the sheet-like base material Sw that has been subjected to the processing of thin film forming through the film forming chamber 1a; and a guide roller 32 which guides the sheet-like base material Sw from the film forming chamber 1a to the take up roller 31. Then, by means of the downstream-side guide roller 23 inside the upstream-side auxiliary chamber 1b and by means of the guide roller 32 inside the downstream-side auxiliary chamber 1c, the sheet-like base material Sw is transferred along the upper space of the film forming chamber 1a horizontally in the X-axis direction and, as a consequence, the lower surface thereof becomes the surface to which the film is formed. In this embodiment each of the above-mentioned elements 21 ∼ 24 and 31, 32 constitute the base material traveling means which cause the sheet-like base material Sw to travel at a predetermined speed.

In the film forming chamber 1a there is provided a sheet-like mask material traveling means 4 for causing to travel the sheet-like mask material Sm which limits the scope of supply of the film forming material to the sheet-like base material Sw relative to the portion Sw1 of the sheet-like base material Sw to be transferred inside the film forming chamber 1a. The mask material traveling means 4 is constituted by a single rack 41 that is made up of a rectangular substrate portion 41a and four plate-like supporting portions 41b which are vertically disposed respectively at the four corners of the substrate portions 41a. On those surfaces of the supporting portions 41b of the rack 41 which lie opposite to each other in the Y-axis direction, two rollers 42a∼42d are respectively rotatably supported at a predetermined clearance therebetween in the vertical direction. A rotary shaft of the roller 42d that is positioned on the left lower side is connected to an electric motor DM2. In this arrangement, a sheet-like mask material Sm is endlessly wound around each of the rollers 42a∼42d and, by means of rotating drive by the motor DM2, the sheet-like mask material Sm travels. In this embodiment, the left-upper-side roller 42a and the right-upper-side roller 42b that are disposed in the X-axis direction at a distance from each other constitute a parallel travel region forming unit which causes that portion Sm1 of the sheet-like base material Sm to travel horizontally at a predetermined vertical clearance relative to that portion Sw1 of the base material Sw which is horizontally transferred inside the film forming chamber 1a. The roller 42d which is positioned on the left lower side and is provided with the electric motor DM2 constitute a driving unit which causes the sheet-like mask material Sm to travel in synchronization with the sheet-like base material Sw.

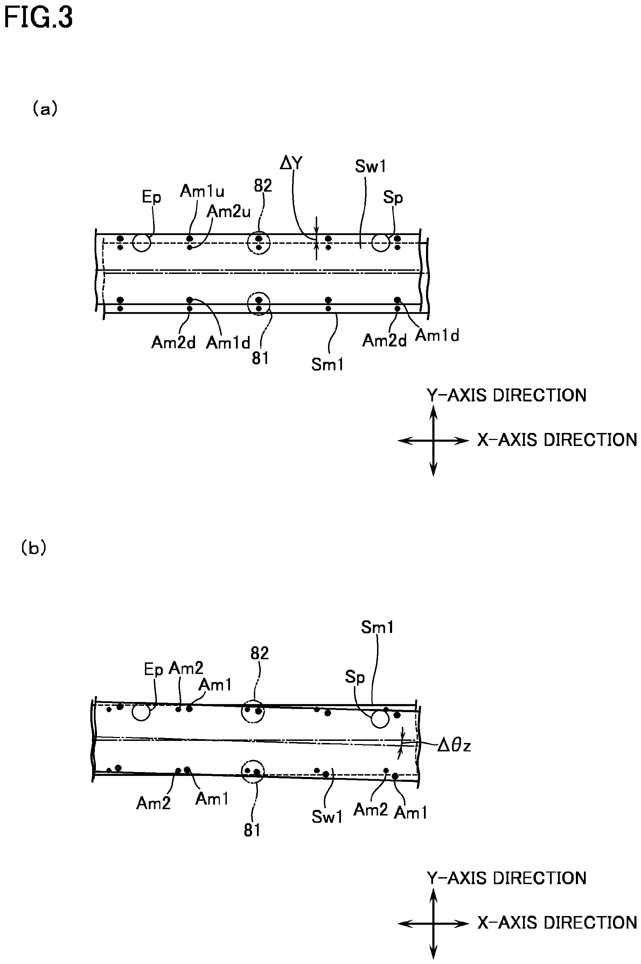

In concrete, based on the feed speed of the sheet-like base material Sw depending on the detected value by the sensor 25, the rotational speed of the motor DM2 is computed. Control is then made such that the feed speed of the sheet-like base material Sw becomes equivalent to the feed speed of the sheet-like mask material Sm. As the sheet-like mask material Sm, there is used one in which are formed openings or slits as mask patterns depending on the patterns to be formed on the sheet-like base material Sw. Further, on both ends of the width direction (Y-axis direction) of the sheet-like base material Sw and the sheet-like mask material Sm, there are formed, at a predetermined spacing (e.g., within a range of 5∼10 mm) in the Y-axis direction on the same X-axial line, alignment marks Am1, Am2 for detecting the amounts of relative displacement ΔX, ΔY and Δ Θz relative to the sheet-like base material Sw (see FIG. 3). The alignment mark Am1 of the sheet-like base material Sw may be constituted, e.g., by a perforated hole which is circular as seen in plan view (i.e., as seen from top downward), and the alignment mark Am2 of the sheet-like mask material Sw may be constituted, e.g., by a perforated hole and the like which is smaller in diameter than the alignment mark Am1. Alignment is made, for example, such that the centers of both the alignment marks Am1, Am2 coincide with each other. Further, for the purpose of controlling and the like of the film forming processing with respect to the sheet-like base material Sw, both ends of the width direction (Y-axis direction) of the sheet-like base material Sw have formed therein marks Sp, Ep which indicate the point of starting detection and the point of ending detection, as distinguished from the alignment marks Am1, Am2. In this case the marks Sp, Ep can be formed of perforated holes which are larger in diameter than the alignment marks Am1, Am2 or may be formed in perforated triangles as seen in plan view. The alignment marks Am1, Am2 may be formed only in one end in the width direction (Y-axis direction) of the sheet-like base material Sw and the sheet-like mask material Sm so that the sheet-like mask material Sm can be aligned relative to the sheet-like base material Sw.

In addition, the film forming chamber 1a is provided with a Y-Θz stage 5 which supports the rack 41. On the Y-Θz stage 5 there are provided linear actuators 6 which are movable in the vertical direction. As the Y-Θz stage 5, since there may be utilized one having the known construction that can perform the movement of the rack 41 in the Y-axis direction, and the one that can perform the rotation of the rack 41 in the Θz direction, and as the linear actuator 6, there may be utilized one having the known construction that can vertically move the entire rack 41 together with the Y-Θz stage. Therefore, detailed explanations thereabout are omitted here. Still furthermore, on the lower surface of the film forming chamber 1a there are disposed rail members 71 which extend in the Y-axis direction. A cart 72 that can travel along the rail members 71 is disposed. On the cart 72 there are disposed the Y-Θz stage 5 and the rack 41 through the linear actuators 6. In this case, doors that can be opened and closed (not illustrated) are disposed on wall surfaces that define the film forming chamber 1a so that the mask material traveling means 4 can be moved into and out of the film forming chamber 1a. In this embodiment the rail members 71 and the cart 72 constitute the moving means which causes the mask material traveling means 4 to be movable inside the film forming chamber 1a and outside the film forming chamber 1a in the Y-axis direction.

Further, on an upper wall surface 11 that defines the film forming chamber 1a, there are disposed two peep holes 12 at a predetermined distance from each other in the Y-axis direction. Above the peep holes 12 there are disposed imaging means 81, 82 such as CCD cameras and the like. In this case, the imaging means 81, 82 are arranged to capture, on both widthwise (Y-axis direction) ends of the sheet-like base material Sw, the relative position of the portion Sm1 or alignment marks Am1, Am2 of the sheet-like mask material Sm relative to the portion Sw1 of the sheet-like base material Sw1 that is transferred horizontally inside the film forming chamber 1a. In this embodiment, both the imaging means 81, 82 constitute a second detecting means for detecting: an amount of relative displacement ΔY in the Y-axis direction of the sheet-like mask material Sm relative to the sheet-like base material Sm; or an angle Δ Θz to be formed by the traveling direction of the sheet-like base material Sw and the traveling direction of the sheet-like mask material Sm. At the same time, both the imaging means 81, 82 serve a dual function as a first detecting means for detecting, in a region Sw1 in which the portion of the sheet-like base material Sm1 and the portion of the sheet-like mask material Sw are in a vertical positional relationship with each other, the amount of relative displacement ΔX in the X-axis direction of the sheet-like mask material Sm relative to the sheet-like base material Sw. Then, the images captured by the imaging means 81, 82 are analyzed by the known image analyzing means, and depending on the analyzed values (detected values), the Y-Θz stage 5 is appropriately moved or rotated, whereby the position of the sheet-like mask material Sm relative to the sheet-like base material Sw is corrected.

In concrete, as exemplified in FIG. 3(a), in case the sheet-like mask material Sm is deviated to one side in the Y-axis direction relative to the sheet-like base material Sw1, the images captured by the imaging means 81, 82 are analyzed by the known image analyzing means to obtain an amount of displacement ΔY. Depending on the amount of displacement, the Y-Θz stage 5 is moved in one Y-axis direction for correction. On the other hand, as exemplified in FIG. 3(b), in case the sheet-like mask material Sm is snaking relative to the sheet-like base material Sw, the images captured by the imaging means 81, 82 are analyzed by the known image analyzing means. In this manner, the angle Δ Θz to be formed by the traveling direction of the sheet-like base material Sw and the traveling direction of the sheet-like mask material Sm (i.e., the tilting of the sheet-like mask material Sm relative to the sheet-like base material Sw on the X-Y plane) is computed. Depending on the angle, by appropriately moving the Y-Θz stage 5 in the Θz-axis direction, the Y-Θz stage 5 is rotated about the Z-axis for correction. In addition, the images captured by the imaging means 81, 82 are similarly analyzed and, depending on the analyzed values (detected values), the number of rotation of the electric motor DM1 or DM2 is increased or decreased. The positions of the sheet-like mask material Sm is corrected relative to the sheet like base material Sw so that both the alignment marks Am1, Am2 vertically overlap each other in the Z-axis direction. The sheet-like base material Sw and the sheet-like mask material Sm are caused to travel in synchronization with each other.

On the side wall surface, in the Y-axis direction, which defines the film forming chamber 1a, there is also provided a peep hole (not illustrated). On a side of the peep hole there is disposed an imaging means 83 such as CCD cameras and the like. In this embodiment, the imaging means 83 constitutes a third detecting means which detects the vertical clearance between the sheet-like base material Sw and the sheet-like mask material Sm in a region in which the portion Sw1 of the sheet-like base material Sw and the portion Sm1 of the sheet-like mask material Sm are positioned in a vertical positional relationship with each other. And the images captured by the imaging means 83 are analyzed by the known image analyzing means. Depending on the analyzed value (detected value), the linear actuators 6 are appropriately moved vertically to thereby correct the height position of the sheet-like mask material Sm relative to the sheet-like base material Sw. The following control and the like may be performed any time during the film forming operation, i.e.: the control of coinciding the feed speed of the sheet-like base material Sw and the feed speed of the sheet-like mask material Sm; correction of the relative position in the X-axis direction and in the Y-axis direction of the portion Sm1 of the sheet-like base material Sw relative to the portion Sw1 of the sheet-like base material Sw to be horizontally transferred inside the film forming chamber 1a; and the correction of the clearance in the vertical direction between the sheet-like base material Sw and the sheet-like mask material Sm. According to this arrangement, the sheet-like mask material Sm can be aligned at high accuracy with the sheet-like mask material Sm, and highly accurate film forming can be performed. Also, blurs due to too large a clearance in the vertical direction can be prevented from occurring to the thin film formed on the base material Sw.

The film forming chamber 1a has disposed therein a film forming means 9 below the portion Sm1 of the sheet-like mask material Sm in a space inside the supporting portion 41b of the rack 41. The film forming means 9 contains therein a film forming material (not illustrated) to be subjected to selection depending on the composition of the thin film to be formed on the sheet-like base material Sw, and is provided with a resistance board 91 for evaporating the film forming material by electric resistance heating, and a box 92 for storing therein the resistance board 91. The film forming means 9 is supported by such side wall surfaces in the Y-axis direction as define the film forming chamber 1a. In this case, the box 92 may also be so constituted as to be pushed into, or pulled out of, the film forming chamber 1a, thereby facilitating the supplementing of the evaporating material or the maintenance of the box 92. Alternatively, a plurality of boxes 92 having therein set in advance the film forming material on the resistance board 91 may be prepared in a plurality of numbers so that, in case the box 92 now in use need be subjected to maintenance, another box 92 may be set in position instead, thereby facilitating the starting again of film forming on the sheet-like base material Sw as soon as possible.

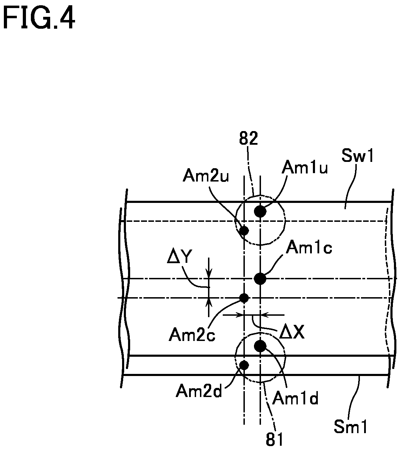

The above-mentioned film forming apparatus DM is provided with a control means Cu which is made up of a personal computer, sequencer, and the like for controlling overall operations of the apparatus. The control means Cu performs: synchronized traveling of the sheet-like base material Sw and the sheet-like mask material Sm; calculation of amounts of correction based on the input of image data captured by the imaging means 81, 82, 83; correction of positions, by the Y-Θz stage 5, of the sheet-like mask material Sm relative to the sheet-like base material Sw; and the like. A description will now be made, with reference to FIG. 4, of an example of a method of film forming by using the above-mentioned film forming apparatus DM.

In the upstream-side auxiliary chamber 1b the sheet-like base material Sw is held by the feed roller 21. The front end of the sheet-like base material Sw is caused to pass, via an upstream-side guide roller 22, the downstream-side guide roller 23 and the dancer roller 24, through the space in an upper portion of the film forming chamber 1a in which the mask material traveling means 4 has been set in position in advance, and is then wound around the take up roller 31 via a guide roller 32. At this time, the sheet-like mask material Sm is moved manually or in a similar manner so that the alignment marks Am1, Am2 are substantially in agreement with each other as seen in the Z-axis direction. Then, when the film forming chamber 1a, the upstream-side auxiliary chamber 1b and the downstream-side auxiliary chamber 1c have been evacuated to a predetermined pressure, the electric motors DM1, DM2 are driven for rotation. The sheet-like base material Sw from the feed roller 21 is thus caused to travel and also in synchronization with the sheet-like base material, the sheet-like mask material Sm is caused to travel. At this time, from the feed speed of the sheet-like base material Sw depending on the values as detected by the sensor 25, the rotational speed of the electric motor DM2 is calculated. Control is then made such that the feed speed of the sheet-like base material Sw becomes equal to the feed speed of the sheet-like mask material Sm. The sheet-like base material Sw and the sheet-like mask material Sm are thus caused to travel by the same length per unit time (travel amount).

Now, the alignment marks positioned on an upper side (as seen in FIG. 4) of the sheet-like base material Sw and of the sheet-like mask material Sm are referred to as Am1u, Am2u, and the alignment marks positioned on a lower side thereof are referred to as Am1d, Am2d, respectively. When a mark of the detection starting point Sp is captured by the imaging means 82, the control means Cu then analyses the captured images of the alignment marks Am1u, Am2u, Am1d, Am2d at the portion Sw1 of the sheet-like base material Sw and at the portion Sm1 of the sheet-like mask material Sm. Detection is then made of an amount of relative displacement ΔX in the X-axis direction, and at least one of amounts of relative displacement Δ Y in the Y-axis direction and angle Δ Θz. In concrete, as shown in FIG. 4, 1) the alignment marks Am1u and Am2u are captured by the imaging means 82 at the same time and image analysis is made to detect the positional differences in the X-axis direction and in the Y-axis direction, respectively, and 2) the alignment marks Am1d and Am2d are captured by the imaging means 81 at the same time and image analysis is made to detect the positional differences in the X-axis direction and in the Y-axis direction, respectively. Then, average values of the positional differences in the X-axis direction and in the Y-axis direction as detected under items 1) and 2) are respectively calculated to thereby obtain relative amounts of displacement ΔX and ΔY at a middle point Am1c between both the alignment marks Am1u, Am1d of the sheet-like base material Sw, and at a middle point Am2c of both the alignment marks Am2u, Am2d of the sheet-like mask material Sm. On the other hand, in relation to the above-mentioned positional difference in the X-axis direction, a difference between the above-mentioned 1) and 2) is calculated. When the product is divided by the distance between the imaging means 81, 82, Δ Θz is calculated. Then, the control means Cu calculates the amount of change in the number of revolutions of the electric motor DM2 (i.e., amount of acceleration in speed or amount of deceleration in speed) based on the detected amount of relative change (ΔX) and gives a command accordingly to correct the position, in the X-axis direction, of the sheet-like mask material Sm relative to the sheet-like base material Sw. In addition, in case of a displacement, e.g., in the Y-axis direction, a command is given of the amount of movement in the Y-axis direction of the Y - Θz stage 5 based on the detected amount of relative displacement (ΔY). For example, in case a displacement has occurred, e.g., in the Θz direction, a command is given of the amount of rotation, about the Z-axis, of the Y-Θz stage 5 based on the angle (Δ Θz) so as to correct the position of the sheet-like mask material Sm relative to the sheet-like base material Sw.

In parallel with the above, the control means Cu analyzes the images, as captured by the imaging means 83, of the clearance in the Z-axis direction between the sheet-like base material Sw and the sheet-like mask material Sm, and detects the relative amount of displacement (Δ z), in the Z-axis direction, of the sheet-like mask material Sm relative to the sheet-like base material Sw. Based on the detected relative amount of displacement (Δ z), a command is given of a vertical amount of movement of the linear actuators 6, thereby correcting the clearance (height position) between the sheet-like base material Sw and the sheet-like mask material Sm.

After having corrected the traveling speed, position, and height position of the sheet-like mask material Sm relative to the sheet-like base material Sw, the control means Cu performs, whenever capturing is made, e.g., at predetermined intervals, of the alignment marks Am1, Am2 at the portion Sw1 of the sheet-like base material Sw and the portion Sm1 of the sheet-like mask material Sm, detecting is made of the amount of relative displacement ΔX, at least one of the amount of relative displacement ΔY and the angle Δ Θz, as well as the clearance between the sheet-like base material Sw and the sheet-like mask material Sm, respectively. Once the detected figures go outside the predetermined range, according to the above procedures, the position and the traveling speed of the sheet-like mask material Sm relative to the sheet-like base material Sw are corrected.

According to the above-mentioned embodiment, each of the rollers 42a∼42d as the parallel travel region forming unit and the driving unit that causes the sheet-like mask material Sm to travel are disposed on a single rack 41 that causes the sheet-like mask material Sm to travel, is formed into a unit as a result of mounting on a single rack 41. In aligning the positions of the portion Sm1 of the sheet-like mask material Sm relative to the portion Sw1 of the sheet-like base material Sw1, the rack 41 itself is moved or rotated. It means that the traveling conditions of the sheet-like mask material Sm to which a predetermined tension has been applied does not change. The forceful strains do neither occur to the sheet-like mask material Sm and, as a consequence, to the mask pattern. It follows that, in addition to the fact that the portion Sm1 of the sheet-like mask material Sm is caused to travel constantly in parallel with the portion Sw1 of the sheet-like base material Sw while keeping a predetermined vertical clearance, film forming can be performed on the sheet-like base material Sw with precise pattern. In addition, since the rack 41 is disposed on the moving means 71, 72, when the rack 41 is pulled out of the vacuum processing chamber 1 for carrying out maintenance and the like, such work can be carried out easily. By the way, an arrangement may alternatively be made that each of the rollers 42a∼42d are disposed on a single rack 41 into a unit, and a sheet-like mask material Sm set in position in advance may be prepared in a plurality of numbers. In case necessity arises that the one in use must be subjected to maintenance (replacement of the sheet-like mask material Sm, cleaning, and the like), the one in use may be replaced for a new one on which, e.g., a cleaned sheet-like mask material Sm has been set in position. In this manner, the film forming work can be started again soonest possible.

By the way, depending on the sheet-like base material Sw, there is a case in which the base material is thermally expanded by radiation heat at the time of evaporating the depositing material through resistance heating by a resistance board 91. In case the sheet-like base material Sw has been thermally expanded in the X-axis direction, even though control is made so as to cause the sheet-like base material Sw and the sheet-like mask material Sm by the same length (travel amount) per unit time as described above, the result will be that the sheet-like base material Sw delays relative to the sheet-like mask material Sm. In this kind of case, it is conceivable to arrange the Y-Θz stage 5 to be movable also in the X-axis direction to enable the correction of the amount of relative displacement ΔX accompanied by the thermal expansion. However, according to this arrangement, correction can be made to the relative amount of displacement ΔX only within a range of amount of traveling of the Y-Θz stage 5 in the X-axis direction. If the delay in the sheet-like base material Sw is accumulated because of a very large length of the sheet-like base material Sw to be processed, there will arise a case in which the position of the sheet-like mask material Sn relative to the sheet-like base material Sw can no longer be corrected. On the other hand, according to the above-mentioned embodiment, the variation of the number of rotation of the electric motor DM2 (i.e., the amount of acceleration or the amount of deceleration) is calculated based on the detected amount of relative displacement (ΔX), and a command is given. The relative amount of displacement of ΔX is added to, or subtracted from, the amount of traveling when the sheet-like base material Sw and the sheet-like mask material Sm are caused to travel in the same amount of traveling per unit time. Therefore, the delay that may happen to the sheet-like base material Sw due to thermal expansion in the X-axis direction can also be corrected. In addition, even in case the sheet-like base material Sw is very long, correction can be made perpetually. Still furthermore, even in case the sheet-like base material Sw is very long, persistent correction is possible. Further, even in case the sheet-like base material Sw has been thermally expanded, the amount of displacement ΔY and the angle Θz have been calculated as described above, alignment can be made so as to minimize the effect of the thermal expansion of the sheet-like base material Sw.

A description has so far been made of the embodiment of this invention, but this invention shall not be limited to the above. In the above-mentioned embodiment, a description has been made of an example in which the elements from the mask material traveling means 4 to the cart 72 are disposed inside the vacuum processing chamber 1. However, an arrangement may alternatively be made in which, e.g., only the mask material traveling means 4 and the Y-Θz stage 5 are disposed inside the vacuum chamber 1 so as to minimize the volume of the vacuum processing chamber 1. In addition, in the above-mentioned embodiment, a description has been made of an example in which the sheet-like mask material Sm is endlessly wound around each of the rollers 42a∼42d. However, without being limited thereto, an arrangement may also be made so as to take up the sheet-like mask material from the feed roller to the take up shaft.

Further, in the above-mentioned embodiment, a description was made of an example in which vapor deposition is carried out by using the resistance board as the film forming means. Without being limited thereto, the film forming means may alternatively be arranged to be a sputtering cathode, or CVD method as a means for supplying raw gas for forming a thin film of a predetermined thickness. Furthermore, in the above-mentioned embodiment, a description was made of an example in which the downstream guide roller 23 is provided with the sensor 25 as a speed detecting means and in which, according to the detected values of the sensor 25, control is made such that the feed speed of the sheet-like base material Sw becomes equal to the feed speed of the sheet-like mask material Sm. However, without being limited thereto, an arrangement may alternatively be made such that, e.g., the feed speed of the sheet-like mask material Sm is detected and that the electric motor DM1 is controlled according to the detected values so that the feed speed Sw of the sheet-like base material Sw can be corrected. In this case, the number of rotation of the electric motor DM2 is increased or decreased, thereby correcting the position of the sheet-like mask material Sm relative to the sheet-like base material Sw so that both the alignment marks Am1, Am2 vertically overlap each other in the Z-axis direction.

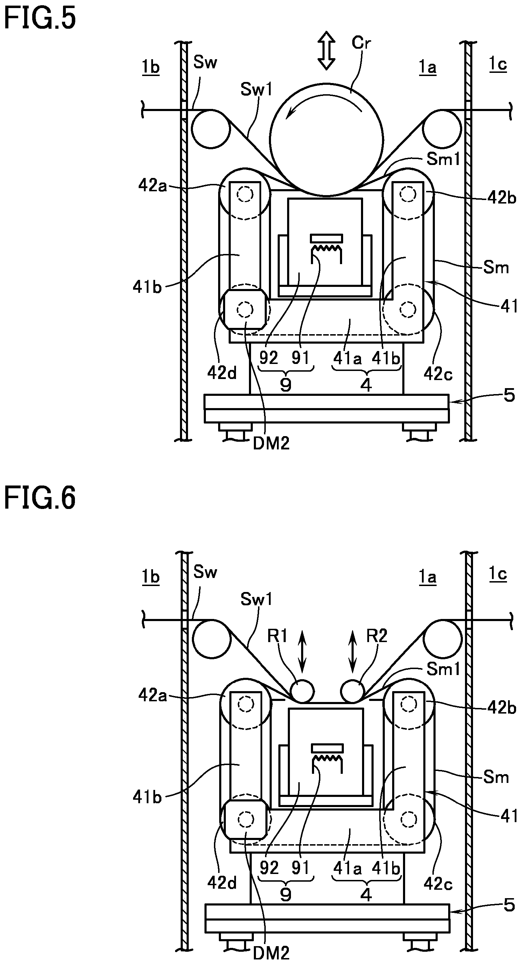

Further, in the above-mentioned embodiment, a description was made of an example in which the portion Sw1 of the sheet-like base material Sw and the portion Sm1 of the sheet-like mask material Sm are caused to travel in parallel with each other at a predetermined vertical clearance from each other. However, without being limited thereto, an arrangement may alternatively be made such that film forming is performed in a state in which the portion Sw1 of the sheet-like base material Sw and the portion Sm1 of the sheet-like mask material Sm are brought into contact with each other. For example, in an embodiment relating to a modified example as shown in FIG. 5, in a manner to lie opposite to the box 92 in which the resistance board 91 is housed, a can roller Cr is disposed on an upper side of the sheet-like base material Sw. The can roller Cr is provided with a linear actuator (not illustrated) so as to be vertically movable in the Z-axis direction. On the other hand, in another embodiment relating to another modified example as shown in FIG. 6, two pressing rollers R1, R2 are disposed on an upper side of the sheet-like base material Sw at a predetermined distance from each other in the X-axis direction in a manner to lie opposite to the box 92 in which the resistance board 91 is housed. Each of the pressing rollers R1, R2 is provided with a linear actuator (not illustrated) so that each of the rollers R1, R2 is vertically movable in the Z-axis direction in a manner interlocked with each other.

Still furthermore, in the above-mentioned embodiment, a description was made of an example in which, when the portion Sw1 of the sheet-like base material Sw and the portion Sm1 of the sheet-like mask material Sm are caused to travel in parallel with each other at a predetermined clearance in the Z-axis direction, a direct-acting actuator 6 that is disposed in the Y-Θz stage 5 causes each of the rollers 42a∼42d to vertically move integrally in the Z-axis direction so as to correct the clearance in the Z-axis direction. However, in the mask material traveling means 40 relating to the modified example, a tilting means 60 is further provided for tilting the portion Sm1 of the sheet-like mask material Sm relative to the portion Sw1 of the sheet-like base material Sw which travel in parallel with each other.

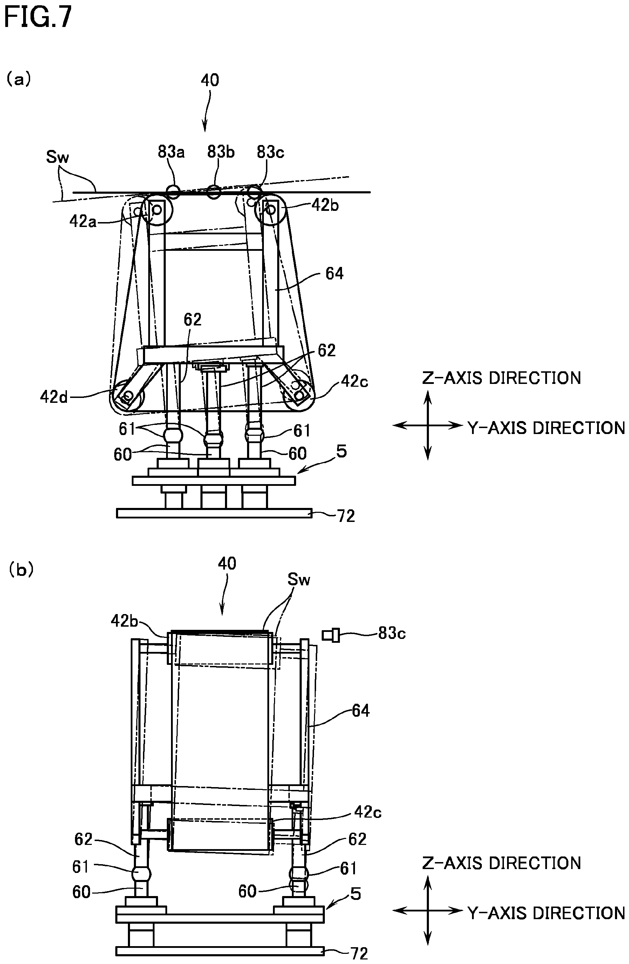

With reference to FIG. 7 for which a description will now be made by using the same reference signs as those in the above-mentioned embodiment, in a mask material traveling means 40 there are provided, at a predetermined distance from each other, three linear actuators 60 on the Y-Θz stage 5 in a manner to be vertically movable in the Z-axis direction. Each of the linear actuators 60 has respectively connected thereto an operation rod 62 through free (spherical) joint 61. By means of the three operation rods 62 a frame 64 to rotatably support each of the rollers 42a∼ 42d is supported. In this case, each of the linear actuators 60, joints 61 and supporting rods 62 constitute the tilting means in this embodiment. Further, such a side wall surface in the Y-axis direction as will define the film forming chamber 1a is provided with a third detecting means. In this embodiment three imaging means 83a∼83c such as CCD cameras and the like are disposed in the X-axis direction at an equal distance from each other. It is thus so arranged that, in the region in which the sheet-like base material Sw and the portion of the sheet-like mask material Sm are in a vertical positional relationship with each other, the images of the sheet-like base material Sw and the sheet-like mask material Sm can be captured in a plurality of positions.

The control means Cu detects the tilting of the sheet-like mask material Sm relative to the sheet-like base material Sw based on the clearance in the Z-axis direction between the portions Sw1 of the sheet-like base material Sw and the portions Sm1 of the sheet-like mask material Sm, as detected by each of the imaging means 83a∼83c. Based on the detected tilting, the amount of the above-mentioned tilting of the sheet-like mask material Sm relative to the sheet-like mask material Sm is commanded to the linear actuator 60 as the tilting means, thereby correcting the above-mentioned tilting. In this case, if the tilting of the sheet-like mask material Sm is corrected by means of the linear actuator 60, the alignment marks Am1, Am2 will be deviated at least in one direction of the X-axis direction and the Y-axis direction. Therefore, after the above-mentioned correction to the tilting, corrections will be made, according to the above-mentioned procedures, of the traveling speed and the position of the sheet-like mask material Sm relative to the sheet-like base material Sw.

On the other hand, in order to correct the position of the sheet-like mask material Sm relative to the sheet-like base material Sw as soon as ever possible, as in the above-mentioned embodiment, the images captured by the imaging means 81, 82 are analyzed to respectively detect the amount of relative displacement value ΔX in the X-axis direction, and at least one of the amount of relative displacement ΔY in the Y-axis direction and the angle Δ Θz. Thereafter, based on the clearance in the Z-axis direction as respectively detected by the imaging means 83a∼83c as the third detection means, tilting of the sheet-like mask material Sm relative to the sheet-like base material Sw is detected. Based on the detected tilting, the amount of tilting of the sheet-like mask material Sm relative to the sheet-like base material Sw is commanded to the linear actuators 60 as the tilting means, thereby correcting the above-mentioned tilting. At the same time, the control means Cu calculates errors of movement, accompanied by the tilting correction, in the X-axis direction and in the Y-axis direction of the sheet-like mask material Sm relative to the sheet-like base material Sw. The error of movement is calculated out into at least one of the amount of relative displacement ΔX, the amount of relative displacement ΔY in the Y-axis direction and the angle Δ Θz. Then, based on the computed amount of relative displacement (ΔZ± α), the amount of movement in the vertical direction of the linear actuator 6 is commanded, thereby correcting the clearance (height position) between the sheet-like base material Sw and the sheet-like mask material Sm.

### Explanation of Reference Signs

DM film forming apparatus
1 vacuum processing chamber
21 feed roller (base material traveling means)
22, 23, 32 guide roller (base material traveling means)
31 take up roller (base material traveling means)
DM1 electric motor (base material traveling means)
4, 40 mask material traveling means
41 rack
42a, 42b roller (parallel travel region forming unit by mask material traveling means)
42d roller with electric motor (driving unit for mask material traveling means)
5 Y-Θz stage
6 linear actuator (drive means)
60 linear actuator (drive means)
61 joint
62 supporting rod
71 cart (moving means)
81- 83 imaging means (each of first∼third detecting means)
9 film forming means
Sw sheet-like base material
Sw1 portion of the sheet-like base material
Sm sheet-like mask material
Sm1 portion of the sheet-like mask material

## Claims

1. A film forming apparatus having, inside a vacuum processing chamber:
a base material traveling means for causing a sheet-like base material to travel at a predetermined speed;
a film forming means for feeding a film forming material to a portion of the sheet-like base material which travels in one direction; and
a mask material traveling means for causing to travel a sheet-like mask material which limits a scope of feeding of the film forming material to the sheet-like base material,
wherein, on condition that a direction from the film forming means toward the sheet-like base material is defined to be upper side, the mask material traveling means comprises:
a parallel travel region forming unit which causes such a portion of the sheet-like mask material as is positioned on a lower side of the sheet-like base material that travels in one direction, to travel in parallel with the sheet-like base material; and
a driving unit which causes the sheet-like mask material to travel in synchronization with the sheet-like base material;
wherein the parallel travel region forming unit and the driving unit are disposed on a single rack.

2. The film forming apparatus according to claim 1, further comprising:
a speed detecting means for detecting a speed at which the sheet-like base material or the sheet-like mask material is caused to travel;
on condition that a direction in which the portion of the sheet-like base material is caused to travel in one direction is defined to be an X-axis direction, a first detecting means for detecting an amount of relative displacement, in the X-axis direction, of the sheet-like mask material relative to the sheet-like base material in a region in which the portion of the sheet-like base material and the portion of the sheet-like mask material are positioned in a vertical positional relationship with each other;
wherein the film forming apparatus is arranged such that: one of the sheet-like base material and the sheet-like mask material is made to coincide with a detected value, by the speed detecting means, of the other of the sheet-like base material and the sheet-like mask material, thereby synchronizing the sheet-like base material and the sheet-like mask material with each other; and that one of the base material traveling means and the driving unit is controlled depending on the detected value by the first detecting means, thereby correcting the position of the sheet-like mask material relative to the sheet-like base material.

3. The film forming apparatus according to claim 1 or 2, on condition that a direction in which the portion of the sheet-like base material is caused to travel in one direction is defined to be an X-axis direction, that the direction crossing the X-axis direction at right angles is defined to be Y-axis direction, and that a direction of rotation about a Z-axis as a vertical direction is defined to be Θz direction,
wherein the rack is disposed on a Y-Θz stage;
the apparatus further comprising:
a second detecting means for detecting, in a region in which the portion of the sheet-like base material and the portion of the sheet-like mask material are positioned in a vertical positional relationship with each other, a relative amount of displacement in the Y-axis direction of the sheet-like mask material relative to the sheet-like base material, or an angle to be formed by the traveling direction of the sheet-like base material and the traveling direction of the sheet-like mask material;
wherein, depending on a detected value by the second detecting means, at least one of movement in the Y-axis direction of, and rotation about the Θ direction of, the rack is performed by the Y-Θz stage, thereby correcting the position of the sheet-like mask material relative to the sheet-like base material.

4. The film forming apparatus according to claim 3, wherein the mask material traveling means causes to parallely travel the portion of the sheet-like mask material at a predetermined vertical clearance to the portion of the sheet-like base material that is caused to travel in said one direction, wherein the Y-Θz stage comprises:
a driving means for vertically moving the Y-Θz stage;
a third detecting means for detecting a vertical clearance between the sheet-like base material and the sheet-like mask material in the region in which the portion of the sheet-like base material and the portion of the sheet-like mask material are positioned in a vertical positional relationship with each other,
wherein, depending on a detected value by the third detecting means, the Y - Θz stage is vertically moved by the driving means, thereby correcting the height position of the sheet-like mask material relative to the sheet-like base material.

5. The film forming apparatus according to any one of claims 1 through 3, further comprising an urging means for urging, in an upper region of the film forming means, the portion of the sheet-like base material toward the portion of the sheet-like mask material so as to bring the sheet-like base material into contact with the sheet-like mask material.

6. The film forming apparatus according to any one of claims 2 through 5, further comprising a moving means for allowing the mask material traveling means to be movable in the Y-axis direction between inside the vacuum processing chamber and outside the vacuum processing chamber.

7. A film forming method for forming a film on a sheet-like base material by using the film forming apparatus according to any one of claims 3 through 6, the method comprising: on condition that alignment marks respectively disposed on the sheet-like base material and on the sheet-like mask material at a predetermined interval from one another in the X-axis direction, the first detecting means and the second detecting means are defined to be imaging means respectively,
capturing with the imaging means the alignment marks in the portion of the sheet-like base material and in the portion of the sheet-like mask material, and analyzing the captured images, thereby detecting:
a relative amount of displacement (ΔX) in the X-axis direction of the sheet-like mask material relative to the sheet-like base material; and
at least one of a relative amount of displacement (ΔY) in the Y-axis direction of the sheet-like mask material relative to the sheet-like base material, and an angle (Δ Θz) formed by a traveling direction of the sheet-like base material and a traveling direction of the sheet-like mask material;
based on the detected relative amount of displacement (ΔX), giving a command of an amount of change in the traveling speed of the sheet-like base material or of the sheet-like mask material to one of the base material traveling means and the driving unit and;
in synchronization therewith, based on at least one of the detected relative amount of displacement (ΔY) and the angle (Δ Θz), giving a command, to the Y - Θz stage, of a movement amount of at least one of the movement in the Y-axis direction and rotation in the Θ direction, of the rack, thereby correcting the traveling speed and the position of the sheet-like mask material relative to the sheet-like base material.

8. The film forming method according to claim 7, wherein the mask material traveling means further comprises: a tilting means for tilting the portion of the sheet-like mask material relative to the sheet-like base material, both said materials being arranged to travel in parallel with each other, the third detecting means being disposed in the X-axis direction in a plurality of numbers at a predetermined distance from one another, the method comprising:
detecting tilts of the sheet-like mask material relative to the sheet-like base material from a distance, as respectively detected by the third detecting means, in the Z-axis direction between the portion of the sheet-like base material and the portion of the sheet-like mask material;
giving a command of an amount of tilting of the sheet-like mask material to the tilting means based on the detected tilts, thereby correcting the tilts and, after correcting the tilts, correcting the traveling speed and the position.

9. The method according to claim 7, wherein the mask material traveling means further comprises: a tilting means for tilting the portion of the sheet-like mask material relative to the portion of the sheet-like base material, both said materials being arranged to travel in parallel with each other, the third detecting means being disposed in the X-axis direction in a plurality of numbers at a predetermined distance from one another, the method comprising:
analyzing the images captured by the imaging means to respectively detect a relative amount of displacement (Δ X) in the X-axis direction, and at least one of a relative amount of displacement (ΔY) in the Y-axis direction and an angle (Δ Θz);
thereafter detecting tilts of the sheet-like mask material relative to the sheet-like base material from the distance in the Z-axis direction between the portion of the sheet-like base material and the portion of the sheet-like mask material as respectively detected by the third detecting means;
correcting the tilts based on the detected tilts by commanding to the tilting means the amount of tilting of the sheet-like mask material relative to the sheet-like base material, and calculating an error of movement in the X-axis direction and in the Y-axis direction of the sheet-like mask material relative to the sheet-like base material accompanied by the correction of the tilts;
commanding to one of the base material traveling means and the driving unit an amount of change in traveling speed of the sheet-like base material or the sheet-like mask material by adding the error of movement to the relative amount of displacement (Δ X), and at least one of the relative amount of displacement (ΔY) in the Y-axis direction and the angle (Δ Θz);
and
in synchronization therewith, commanding the amount of movement of at least one of the movement in the Y-axis direction of, and the rotation in the Θ direction of, the rack, thereby correcting the traveling speed of, and the position of, the sheet-like mask material relative to the sheet-like base material.
